# DEMANDE DE BREVET EUROPEEN

(11) **EP 2 410 557 A2**
(43) Date de publication de la demande: **25.01.2012**
(21) Numéro de dépôt: 11174565.9
(22) Date de dépôt: 19.07.2011
(51) Int. Cl.: H01L 21/033

(54) **Procede de realisation de deux motifs imbriques sur un substrat.**

(30) Priorité: 22.07.2010 FR 1055979
(71) Demandeur: STMicroelectronics (Grenoble 2) SAS, 38000 Grenoble (FR); Commissariat à l'Énergie Atomique et aux Énergies Alternatives, 75015 Paris (FR)
(72) Inventeur: Morand, Yves, 38000 GRENOBLE (FR); Poiroux, Thierry, 38500 VOIRON (FR)
(74) Mandataire: Zapalowicz, Francis

(57) **Abrégé**

Procédé de réalisation de deux motifs imbriqués sur un substrat (1).

Le procédé comprend par photolithographie et gravure, une réalisation sur le substrat d'un premier motif (2) d'un premier matériau comprenant des zones en relief (2a) séparées par des zones en creux (2b), un dépôt non conforme d'un deuxième matériau (3) sur le premier motif (2) formant des cavités (4) dans lesdites zones en creux (2b) du premier motif (2), une ouverture desdites cavités (4), un remplissage par un troisième matériau (5) desdites cavités (4) ouvertes et un retrait du deuxième matériau (3), le troisième matériau (5) formant un deuxième motif imbriqué avec le premier motif (2).

## Description

L'invention concerne la réalisation de motifs imbriqués, en particulier auto-alignés, sur un substrat, en particulier semi-conducteur, notamment pour la fabrication de circuits intégrés.

Les industries du domaine technologique des semi-conducteurs cherchent perpétuellement à réaliser des dispositifs électroniques tels que des circuits intégrés de plus en plus petits, de plus en plus rapides, et possédant une densité d'éléments électroniques la plus élevée possible.

Une technique bien connue de réalisation de motifs sur un substrat semi-conducteur consiste à utiliser une technique de photolithographie. Selon cette technique, un motif, tel qu'un ensemble de lignes parallèles, est réalisé sur le substrat par dépôt d'une couche de matériau sur le substrat, création par photolithographie d'un masque de résine comportant des ouvertures correspondant à un motif complémentaire du motif à réaliser, puis gravure du matériau à travers le masque et retrait de la résine.

Une éventuelle étape ultérieure de transfert dans le substrat consiste à graver le substrat en utilisant le motif réalisé comme masque dur.

Cependant, cette méthode de photolithographie optique est limitée par la longueur d'onde utilisée par la source lumineuse insolant la résine. En effet, actuellement celle-ci ne permet pas de réaliser des lignes ayant une largeur inférieure ou égale à 45nm.

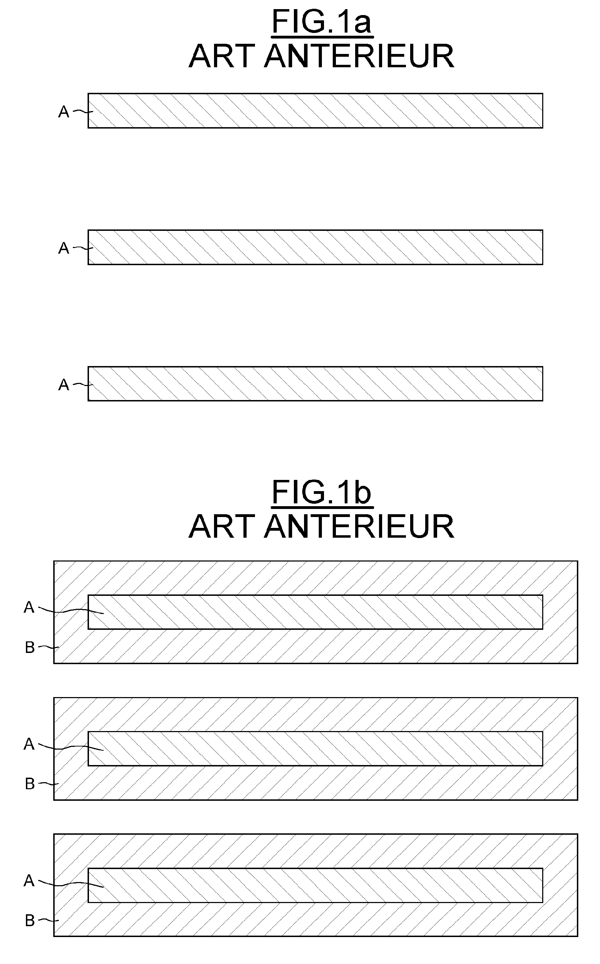

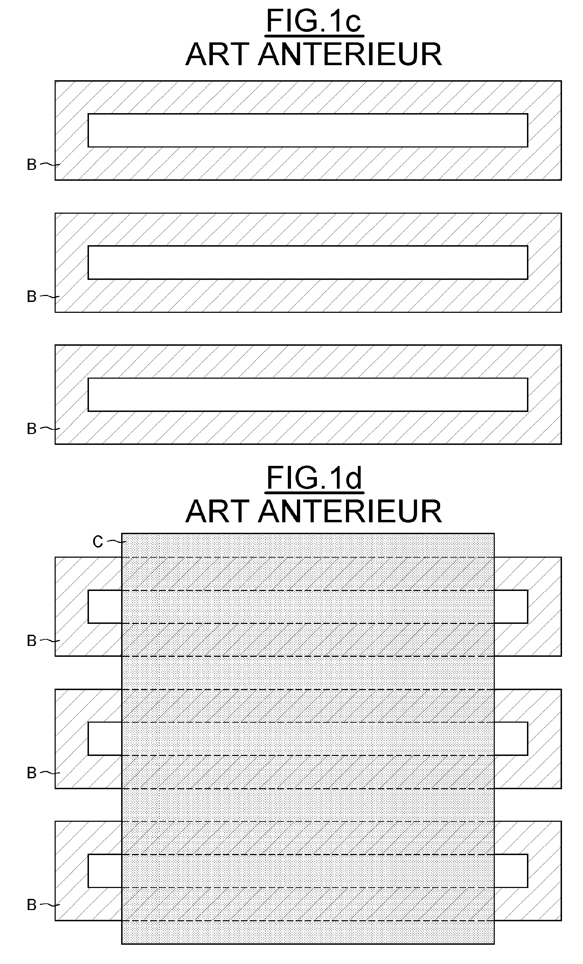

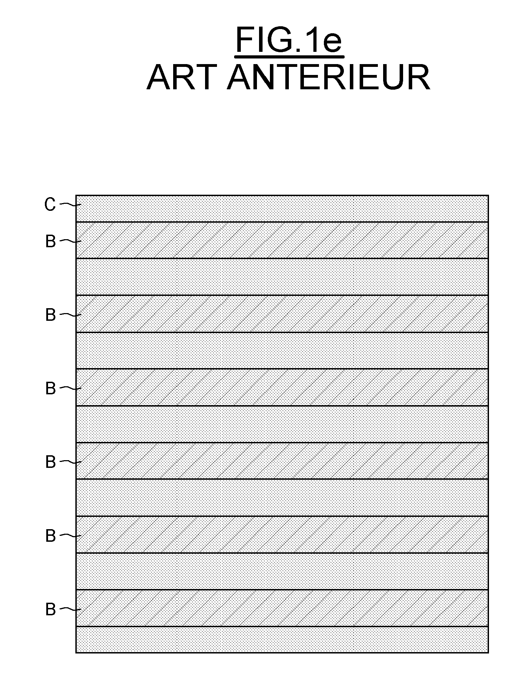

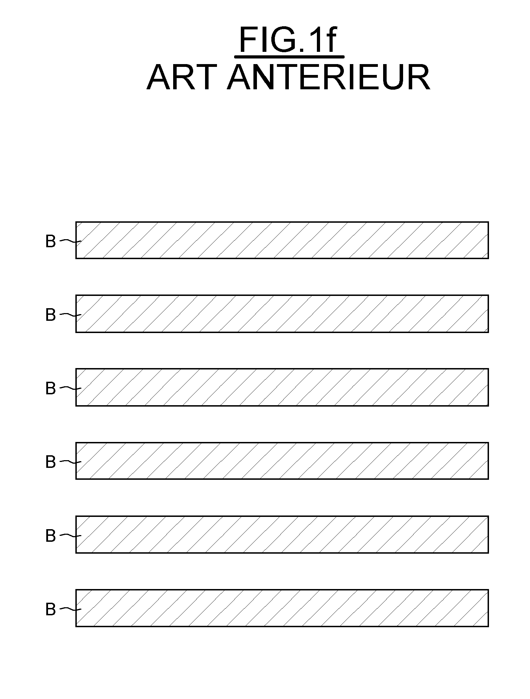

Aussi a-t-il été proposé une autre technique connue par l'homme du métier sous la dénomination anglo-saxonne de « SIT », « Sidewall Image Transfer ». Une réalisation de motifs imbriqués selon cette technique est décrite sur les figures 1a à 1f. Dans une première étape illustrée sur la figure 1a, on réalise sur le substrat par photolithographie et gravure des lignes en un matériau A. Puis, dans une seconde étape illustrée sur la figure 1b, on forme un espaceur en un matériau B autour de chaque ligne du matériau A. Puis, dans une troisième étape illustrée sur la figure 1c, le matériau A est éliminé par une gravure sélective, ne laissant alors subsister que les espaceurs en matériau B. Dans une quatrième étape illustrée sur la figure 1d, une autre étape de photolithographie est réalisée avec un masque de résine de manière à éliminer, dans une étape suivante illustrée sur la figure 1e, les extrémités des espaceurs en matériau B, et ainsi obtenir, à l'issue d'une étape finale de retrait de la résine, illustrée sur la figure If, une succession de lignes en matériau B séparées d'un intervalle deux fois plus petit que les lignes obtenues initialement par photolithographie en matériau A.

Cependant, cette méthode nécessite deux étapes de photolithographies.

Selon un mode de réalisation et un mode de mise en oeuvre, il est proposé un procédé de formation de deux motifs imbriqués sur un substrat semi-conducteur, notamment auto-alignés, et séparés d'un espace étroit et permettant de n'utiliser qu'une seule étape de lithographie.

Selon un aspect, il est proposé un procédé de réalisation de deux motifs imbriqués sur un substrat comprenant, par photolithographie et gravure, une réalisation sur le substrat d'un premier motif d'un premier matériau comprenant des zones en relief séparées par des zones en creux, un dépôt non conforme d'un deuxième matériau sur le premier motif formant des cavités dans lesdites zones en creux du premier motif, une ouverture desdites cavités, un remplissage par un troisième matériau desdites cavités ouvertes et un retrait du deuxième matériau, le troisième matériau formant un deuxième motif imbriqué avec le premier motif.

La formation du deuxième matériau de manière à créer des cavités peut être obtenue par exemple par un dépôt non conforme d'un matériau comme du SiO₂, par exemple, ou bien par pulvérisation de ce même matériau, ces exemples n'étant pas limitatifs.

Un dépôt non conforme peut, par exemple, être réalisé par dépôt chimique en phase vapeur assisté par plasma (PECVD) ou bien par dépôt physique en phase vapeur (PVD).

L'ouverture des cavités peut être réalisée par exemple par une technique de polissage mécano chimique (CMP).

Le remplissage des cavité peut, quant à lui, être réalisé par un dépôt à la tournette (Spin on) suivi d'un polissage mécano chimique (CMP) ou d'une gravure pour éliminer la couche résiduelle du troisième matériau à la surface du deuxième matériau.

Le retrait du deuxième matériau peut être réalisé par gravure sélective.

Avantageusement, le premier motif peut comporter des zones en relief équidistantes et être configuré de sorte que ledit dépôt non conforme du deuxième matériau conduise à la formation de cavités respectivement situées à équidistance des zones en relief.

Afin d'obtenir une formation de cavités respectivement situées à équidistance des zones en relief, il est préférable que les zones en relief adjacentes à la cavité soient de même hauteur.

La distance séparant deux zones en relief n'est de préférence pas trop grande par rapport à la hauteur des reliefs. En effet, une distance de séparation des deux zones en reliefs trop importantes par rapport à la hauteur des zones en relief pourrait empêcher la formation d'une cavité entre ces deux zones en relief. Les dimensions (distance entre les zones en relief et hauteur des zones en relief) permettant d'obtenir des cavités lors d'un dépôt non conforme d'un matériau sur les zones en relief et les zones en creux sont bien connus de l'homme du métier, compte tenu des caractéristiques du type de dépôt et du matériau utilisé. L'homme du métier saura donc ajuster ces dimensions compte tenu notamment du matériau utilisé pour obtenir des cavités de dimensions désirées.

On peut avantageusement réaliser un premier motif comportant des premières lignes parallèles équidistantes et réaliser un deuxième motif comportant des deuxièmes lignes parallèles imbriquées entre les premières lignes et à équidistance entre les premières lignes.

Le premier matériau du premier motif et le troisième matériau du deuxième motif peuvent être identiques ou différents.

On peut également réaliser, dans un autre mode de mise en oeuvre, un premier motif comportant au moins deux zones en relief en forme de pointe et former entre les deux zones en pointe une cavité conduisant après remplissage par le troisième matériau et retrait du deuxième matériau à la formation d'un point entre les deux zones en pointe.

D'autres avantages et caractéristiques de l'invention apparaîtront à l'examen de la description détaillée de modes de mise en oeuvre, nullement limitatifs, et des dessins annexés sur lesquels :
- les figures 1a à If, déjà citées, représentent un procédé d'obtention de motifs par la technique dite de « Sidewall Image Transfer » selon l'art antérieur ;
- la figure 2 représente un organigramme d'un procédé de réalisation de deux motifs sur un substrat selon un mode de mise en oeuvre ;
- les figures 3a à 3e illustrent, dans une vue en coupe, des étapes du procédé de réalisation de deux motifs sur un substrat selon le mode de réalisation présenté sur la figure 2 ; et
- les figures 4 et 5 représentent schématiquement des vues d'exemples de motifs.

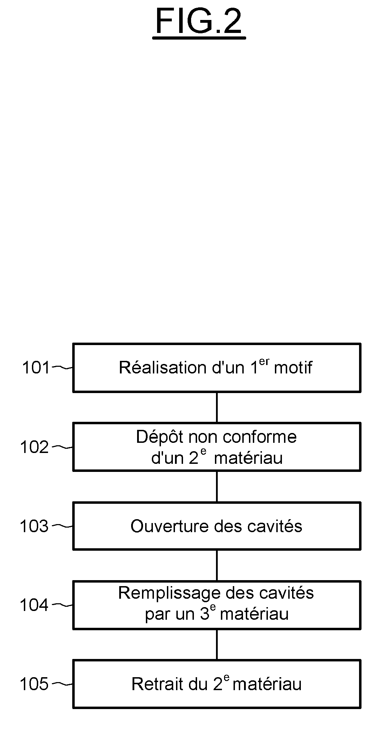

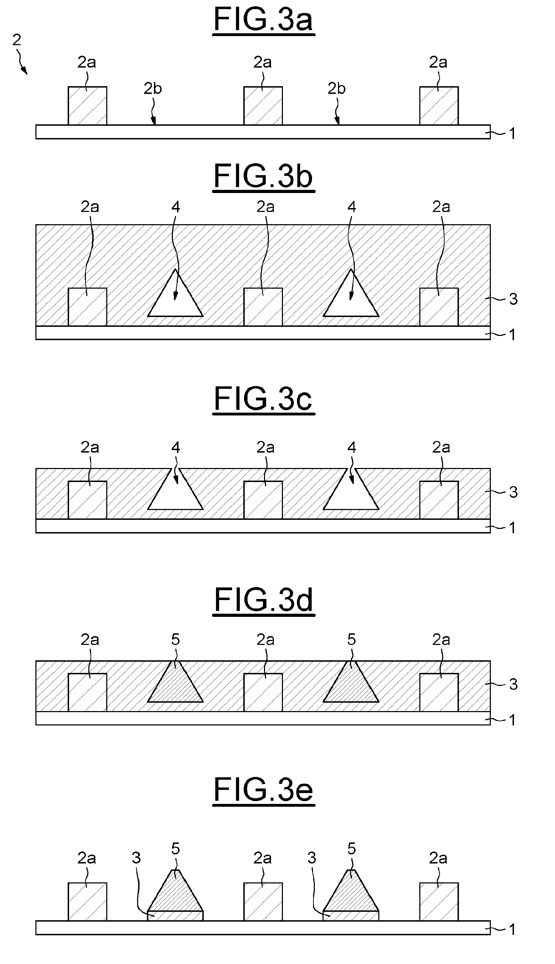

Si l'on se réfère maintenant aux figures 2 et 3a à 3e, on voit que dans une première étape 101, on réalise sur le substrat 1 un premier motif 2 d'un premier matériau comprenant des zones en relief 2a séparées par des zones en creux 2b. La réalisation de ce premier motif sur le substrat 1 est illustrée sur la vue en coupe de la figure 3a, sur laquelle, à titre d'exemple, les trois zones en relief 2a sont des lignes et les deux zones en creux 2b sont des espaces séparant deux zones 2a consécutives. Le premier matériau est par exemple un nitrure de silicium (Si₃N₄), ou bien du silicium ou un métal.

Dans une étape suivante 102, on réalise un dépôt non conforme d'un deuxième matériau 3, par exemple du dioxyde de silicium (SiO₂). Le dépôt non conforme est réalisé, par exemple, par dépôt chimique en phase vapeur assisté par plasma (PECVD). Ce dépôt non conforme permet de recouvrir le substrat 1 et le premier motif 2 en premier matériau avec le deuxième matériau 3. Comme illustré sur la figure 3b, le dépôt non conforme entraîne alors la formation de cavités 4 dans les zones en creux 2b.

Un dépôt non conforme peut également être réalisé par pulvérisation de dioxyde de silicium (SiO₂) sur le substrat. Ce type de dépôt s'avère, en effet, entraîner une formation de cavités au bas des espaces creux entre les motifs métalliques.

Les dimensions (distance entre les zones en relief et hauteur des zones en relief) permettant d'obtenir des cavités lors d'un dépôt non conforme d'un matériau sur les zones en relief et les zones en creux sont bien connus de l'homme du métier, compte tenu des caractéristiques du type de dépôt et du matériau 3 utilisé. L'homme du métier saura donc ajuster ces dimensions compte tenu notamment du matériau utilisé pour obtenir des cavités de dimensions désirées. A titre indicatif, l'homme du métier pourra se référer à toute fin utile au document « A study of voids in sputtered Si02 », de Logan et al., à la page 1392 de la revue J. Vac. Sci. Technol. A 7 (3), May/Jun 1989, et au document « Multi levels air gap intégration using sacrificial material approach for advanced Cu interconnects technologies » de Gras et al., ADMETA, Advanced Metallization Asian Session, (2008).

Outre du SiO₂, on peut également utilise comme deuxième matériau 3, par exemple, du nitrure de silicium ou bien du carbone amorphe.

Dans une étape suivante 103 illustrée sur la figure 3c, on réalise une ouverture des cavités 4, par exemple par polissage mécano chimique (CMP) sur toute la surface de l'ensemble constitué par le substrat 1 semi-conducteur, le premier motif 2 en premier matériau, et le deuxième matériau 3. Ce polissage mécano chimique est ici réalisé sur le matériau 3 uniquement, les cavités se formant généralement sur une hauteur supérieure à la hauteur des zones de relief 2a du premier motif 2 en premier matériau.

L'ouverture des cavités réalisée dans l'étape 103 permet, dans une étape suivante 104 illustrée sur la figure 3d, de remplir les cavités 4 avec un troisième matériau 5. Ce troisième matériau peut être par exemple un oxyde de type SOG (Spin On Glass), un polymère, ou un métal. Ce remplissage des cavités peut être réalisé par un dépôt à la tournette (Spin on) du matériau 5, suivi d'un polissage mécano chimique afin d'éliminer la couche résiduelle de matériau 5 à la surface du matériau 3. On obtient alors une surface principalement constituée par le matériau 3 entrecoupées de zones laissant apparaître le matériau 5. Ce matériau 5 peut être identique au premier matériau.

Le remplissage peut être également être réalisé par dépôt chimique en phase vapeur (CVD), en particulier lors de l'utilisation d'un métal pour troisième matériau.

Enfin, dans une étape finale 105, le matériau 3 est retiré, par exemple, par gravure sélective du matériau 3 le troisième matériau 5 formant ainsi un deuxième motif imbriqué avec le premier motif 2 en premier matériau comme illustré sur la figure 3e.

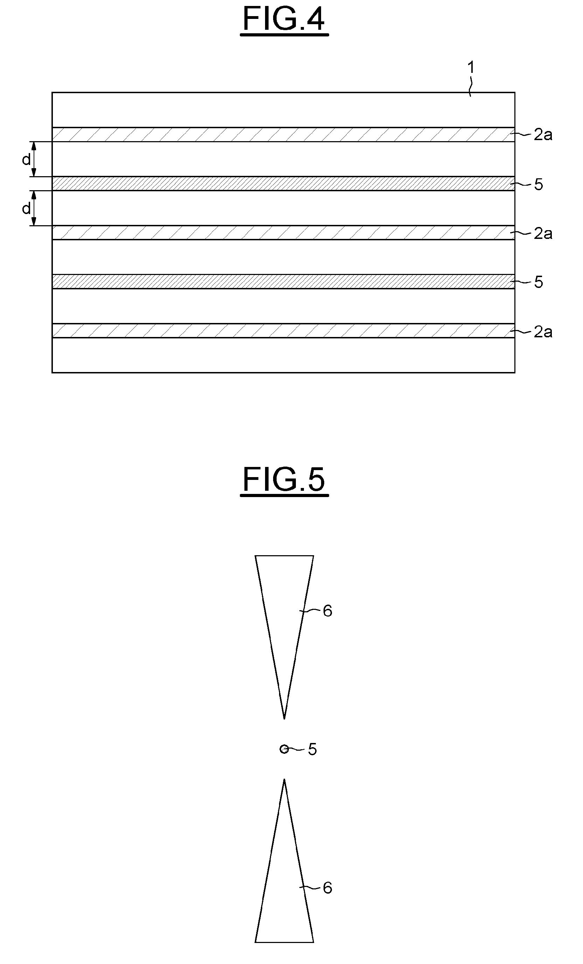

La figure 4 illustre le cas où les deux motifs imbriqués et auto-alignés sont des lignes parallèles équidistantes 5. Ceci permet d'obtenir avec une seule étape de photolithographie des lignes espacées d'une distance d inférieure à la finesse de gravure définie par la photolithographie.

Sur la figure 5, a été représenté un autre exemple de motifs. Un premier motif comporte deux zones en relief 6 en forme de pointe sur un substrat semi-conducteur. A la suite d'un dépôt non conforme d'un matériau comparable au matériau 3 sur le premier motif, une cavité se forme en forme de trou sphérique. Après ouverture de cette cavité, celle-ci est alors remplie avec un matériau comparable au matériau 5. Une fois le matériau comparable au matériau 3 retiré, il ne reste alors plus que les deux zones de relief 6 en forme de pointe entre lesquelles se trouve un point en un matériau comparable au matériau 5 (deuxième motif).En faisant varier la forme des zones en relief 6 il est possible d'agir sur la forme de la cavité et ainsi de mieux définir le point si besoin est.

Ce mode de réalisation permet ainsi la réalisation de transistors mono électronique (dénommés SET en anglais pour Single Electronic Transistor).

## Revendications

1. Procédé de réalisation de deux motifs imbriqués sur un substrat (1), **caractérisé en ce qu'**il comprend par photolithographie et gravure, une réalisation sur le substrat d'un premier motif (2) d'un premier matériau comprenant des zones en relief (2a) séparées par des zones en creux (2b), un dépôt non conforme d'un deuxième matériau (3) sur le premier motif (2) formant des cavités (4) dans lesdites zones en creux (2b) du premier motif (2), une ouverture desdites cavités (4), un remplissage par un troisième matériau (5) desdites cavités (4) ouvertes et un retrait du deuxième matériau (3), le troisième matériau (5) formant un deuxième motif imbriqué avec le premier motif (2).

2. Procédé selon la revendication 1, dans lequel le premier motif (2) comporte des zones en relief (2a) équidistantes et est configuré de sorte que ledit dépôt non conforme du deuxième matériau (3) conduit à la formation de cavités (4) respectivement situées à équidistance des zones en relief (2a).

3. Procédé selon la revendication 1 ou 2, dans lequel on réalise un premier motif (2) comportant des premières lignes parallèles équidistantes et on réalise un deuxième motif comportant des deuxièmes lignes parallèles imbriquées entre les premières lignes et à équidistance des premières lignes.

4. Procédé selon la revendication 1, dans lequel on réalise un premier motif (2) comportant au moins deux zones en relief en forme de pointe (6) et on forme entre les deux zones en pointe (6) une cavité (4) conduisant après remplissage par le troisième matériau (5) et retrait du deuxième matériau (3) à la formation d'un point entre les deux zones en pointe (6).
